# EUROPÄISCHE PATENTSCHRIFT

(11) **EP 1 732 131 B1**
(45) Veröffentlichungstag und Bekanntmachung des Hinweises auf die Patenterteilung: **26.08.2009**
(21) Anmeldenummer: 06111304.9
(22) Anmeldetag: 17.03.2006
(51) Int. Cl.: H01L 23/367

(54) **Anordnung zur Kühlung einer Gruppe von leistungselektronischen Bauelementen**
Assembly adapted to cool a group of power electronic components
Assemblage pour dissipation de chaleur d'un groupe de composants electroniques de puissance

(30) Priorität: 06.06.2005 AT 3712005 U
(43) Veröffentlichungstag der Anmeldung: 13.12.2006
(73) Patentinhaber: Osram Gesellschaft mit beschränkter Haftung, 81543 München (DE)
(72) Erfinder: Hellinger, Leopold, 3710, Ziersdorf (AT); Neumann, Gerhard, 3231, St. Margarethen (AT)
(74) Vertreter: Peham, Alois

(56) Entgegenhaltungen:
- EP-A- 0 340 520
- EP-A- 1 300 883
- US-A- 5 315 480
- US-A1- 2005 201 063
- US-A1- 2005 276 021

## Beschreibung

### Technisches Gebiet

Die Erfindung betrifft eine Anordnung zur Kühlung einer Gruppe von leistungselektronischen Bauelementen, die am Rand einer Leiterplatte angeordnet ist.

### Stand der Technik

Zur Kühlung von elektronischen Bauelementen, die durch Oberflächenmontage (SMD Surface Mounted Device) auf einer Leiterplatte montiert sind, ist die Verwendung von Kühlkörpern bekannt, welche im Zuge des automatischen Lötvorgangs auf die Leiterplatte gelötet werden. Ferner ist bekannt, den Kühlkörper auf der Leiterplattenunterseite anzuordnen und durch thermische Durchkontaktierung, durch so genannte "thermal vias", eine wärmeleitende Verbindung zwischen Kühlkörper und SMD-Bauteil herzustellen.

Eine weitere Möglichkeit besteht darin, die Leiterplatte selbst gut wärmeleitend auszuführen und als Wärmesenke heranzuziehen. Dies kann beispielsweise durch sog. Metall-Leiterplatten erfolgen, die eine gut wärmeleitende Schicht, z.B. eine Aluminiumschicht beinhalten. Von Nachteil ist hierbei, dass auch angrenzende Bauelemente erhitzt werden. Zudem ist die Herstellung einer derartigen Leiterplatte aufwändig.

Oft ist es in der Praxis deshalb so, dass leistungselektronische SMD-Halbleiterbauelemente, wie Dioden, MOSFET und IGBT in D2PACK- oder DPACK-Gehäuse nur mit einem Bruchteil jener Leistung betrieben werden, die bei einer guten Entwärmung möglich wäre.

Aus der EP 0 340 520 B1 ist eine Anordnung zur konvektiven Kühlung von Bauelementen bekannt, die einen Kühlkörper aufweist, der aus zwei übereinander angeordneten Teilen zusammengesetzt ist. Die beiden Teile bestehen aus einem gut wärmeleitenden Material. Der obere Teil des Kühlkörpers ist eine Platte, die Kühlrippen trägt. Der untere Teil des Kühlkörpers besteht aus zwei Kunststoff-Metall-Verbundfolien, wobei die untere Kunststoff-Metall-Verbundfolie Ausformungen aufweist. In einer Ausführungsform sind diese Ausformungen mit einer hochviskosen Wärmeleitpaste gefüllt. Die Ausformungen besitzen eine flexible Außenkontur, die in einem zusammengebauten Zustand gegen die zu kühlende Bauelemente-Anordnung gepresst wird. Auf diese Weise wird eine wärmeleitende Verbindung zum oberen Teil des Kühlkörpers hergestellt und die in den Bauelementen anfallende Verlustleistung zu den Kühlrippen geleitet. Von dort wird sie durch natürliche oder erzwungene Luftkonvektion abgeführt.

Von Nachteil ist hierbei, dass nur die Anlagefläche der Kunststoff-Metall-Verbundfolie als Wärmedurchtrittsfläche wirkt, wodurch die maximal abführbare Wärmemenge begrenzt ist. Der Aufbau besteht außerdem aus einer Vielzahl von Einzelteilen, was Herstellung und Montage entsprechend aufwändig macht.

### Darstellung der Erfindung

Es ist eine Aufgabe der Erfindung, eine Anordnung zur konvektiven Kühlung von leistungselektronischen Bauelementen, die in Gruppen am Rand einer Leiterplatte angeordnet sind, anzugeben, die eine verbesserte Wärmeabfuhr ermöglicht und welche in der Herstellung und Montage einfach und kostengünstig ist.

Diese Aufgabe wird durch die Merkmale des Anspruchs 1 gelöst. Vorteilhafte Ausgestaltungen der Erfindung sind Gegenstand von abhängigen Ansprüchen.

Gemäß der Erfindung ist vorgesehen, dass in einem zusammengebauten Zustand der Rand der Leiterplatte zwischen dem Kühlkörper-Oberteil und dem Kühlkörper-Unterteil durch Verbindungsmittel gehalten ist, dass das Kühlkörper-Oberteil Ausbuchtungen aufweist, dass die Innenfläche jeder Ausbuchtung mit der Außenfläche eines Bauelementes durch einen Spalt beabstandet ist und dass der Spalt durch eine hochviskose, elektrisch nicht leitende Wärmeleitpaste gefüllt ist. Dadurch wird die Verlustwärme allseitig gut abgeleitet. Der Hauptvorteil der erfindungsgemäßen Anordnung ist darin zu sehen, dass sie trotz einfachem Aufbau eine sehr effiziente Wärmeabfuhr ermöglicht. Kostenaufwendige Baukomponenten oder Werkstoffe sind nicht erforderlich. Die Montage ist automatisierbar und damit der Großserienfertigung zugänglich.

Bevorzugt ist dabei eine Anordnung, bei der die Ausbuchtungen im Kühlkörper-Oberteil jeweils in Form und Lage der Gruppe der Bauelemente auf der Leiterplatte angepasst ist. Die Kühlkörperteile können durch Tiefziehen oder Fließpressen so präzise hergestellt werden, dass der Spalt zwischen der inneren Fläche einer Ausbuchtung und der Außenfläche eines Bauteils gering gehalten werden kann.

Besonders vorteilhaft ist es dabei, wenn die Wärmeleitpaste Partikel enthält die als Distanzhalter fungieren und dabei eine Minimalspalt gewährleisten, so dass elektrische Kurzschlüsse vermieden werden. Günstig ist in der Praxis ein mittlerer Partikeldurchmesser von etwa 0,25 Millimeter.

Sehr gute Wärmeableitung lässt sich dadurch erreichen, wenn das Kühlkörper-Oberteil eine sich in Ebene der Leiterplatte erstreckende Fortsetzung aufweist, an der Kühlrippen ausgebildet sind. Dadurch wird die Verlustwärme von der Leiterplatte weg geleitet und kann durch natürliche oder erzwungene Konvektion durch ein kühles Fluid, zum Beispiel Kühlluft abgeführt werden.

Mit Vorteil verlaufen diese Kühlrippen parallel zur Kante des Randes der Leiterplatte und lassen sich auf einfache Weise durch mäanderförmige Umbiegungen beim Fließpressteil kostengünstig herstellen.

Bevorzugt sind diese Umbiegungen des Mäanders in einer U-förmigen Wanne des unteren Kühlkörperteils aufgenommen, wodurch ein Kanal für die vorbeiströmende Kühlluft gebildet wird.

Hinsichtlich der Wärmeabfuhr ist es günstig, wenn die Bauelemente auf einer Lötfläche gelötet sind, die einen überstehenden Rand aufweisen und dieser Rand von der Wärmeleitpaste benetzt ist. Dadurch ist es möglich, den von jedem Bauelement in Richtung der Leiterplatte gerichteten Wärmestrom effizient nach Außen abzuleiten.

Die Wärmeableitung lässt sich weiters dadurch verbessern, dass Wärmeleitkanäle vorgesehen sind, welche mit Wärmeleitpaste gefüllt sind und eine wärmeleitende Verbindung zwischen der Kühlkörper-Oberseite und der Kühlkörper-Unterseite herstellen.

Die Verbindungsmittel zwischen Kühlkörper-Oberteil und Kühlkörper-Unterteil sind bevorzugt formschlüssige Verbindungen, wie zum Beispiel Nietverbindungen. Sie weisen bevorzugt Nietdome auf, die am oberen und/oder unteren Kühlkörperteil ausgebildet sind. Diese Nietverbindungen erfüllen neben der Funktion der mechanischen Halterung auch die Funktion der Wärmeleitung zwischen den beiden Kühlkörperteilen.

Die Nietdome können vorteilhaft mit geringem Aufwand bereits beim Fließpressen in einem Arbeitsgang hergestellt werden.

Bevorzugt ist auch, dass im Bereich einer Ausbuchtung herum mehr Nietverbindungen ausgeführt sind, als für die bloße mechanische Verbindung der beiden Kühlkörperteile notwendig wäre. Auf diese Weise wird unmittelbar an der Wärmequelle die Verlustleistung effizient auf die beiden Kühlkörperteile gebracht.

### Kurzbeschreibung der Zeichnungen

Zur weiteren Erläuterung der Erfindung wird im nachfolgenden Teil der Beschreibung auf die Zeichnungen Bezug genommen in denen weitere vorteilhafte Ausgestaltungen, Einzelheiten und Weiterbildungen der Erfindung zu entnehmen sind.
Es zeigen:
- Figur 1: ein Ausführungsbeispiel der erfindungsgemäßen Kühlvorrichtung, in einer Darstellung vor dem Zusammenbau, bei der die beiden Teile des Kühlkörpers auseinander gezogen sind;
- Figur 2: die erfindungsgemäße Kühlvorrichtung in einem zusammengebauten Zustand mit Sicht auf die Bestückungsseite;
- Figur 3: die erfindungsgemäße Kühlvorrichtung in einem zusammengebauten Zustand mit Sicht auf die Leiterplattenseite;
- Figur 4: eine Detaildarstellung des oberen Kühlkörperteils bei der eine Ausbuchtung geschnitten dargestellt ist und die Sicht auf das darunter liegende Bauelement freigibt;
- Figur 5: eine Detaildarstellung des oberen Kühlkörperteils, in einem Schnitt der durch Nietdome verläuft;
- Figur 6: eine Schnittdarstellung eines Details im Bereich eines aufgelöteten Bauelementes mit Partikel in der Wärmeleitpaste.

### Ausführung der Erfindung

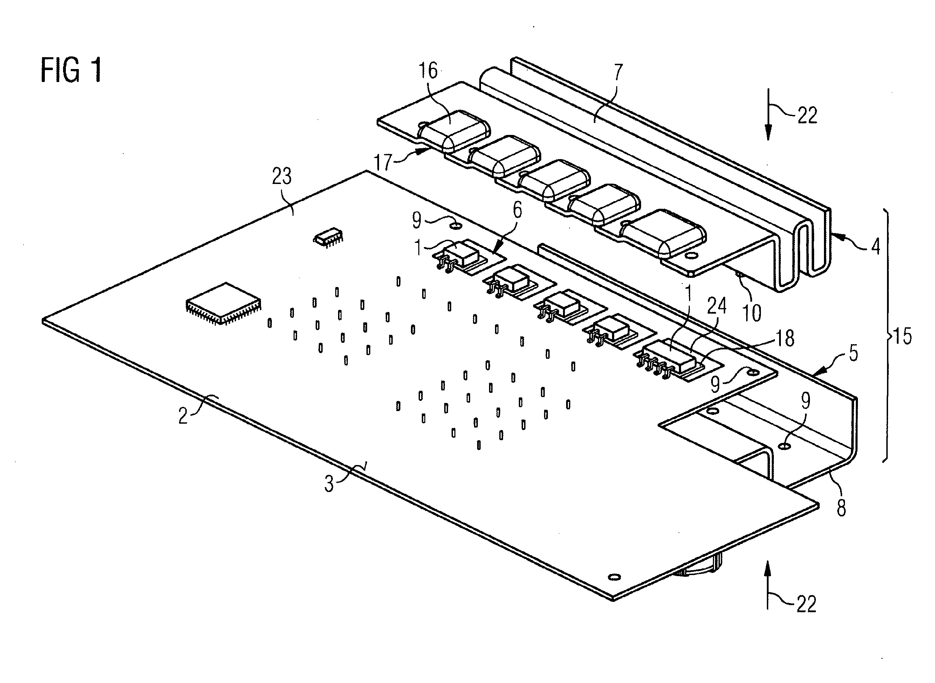

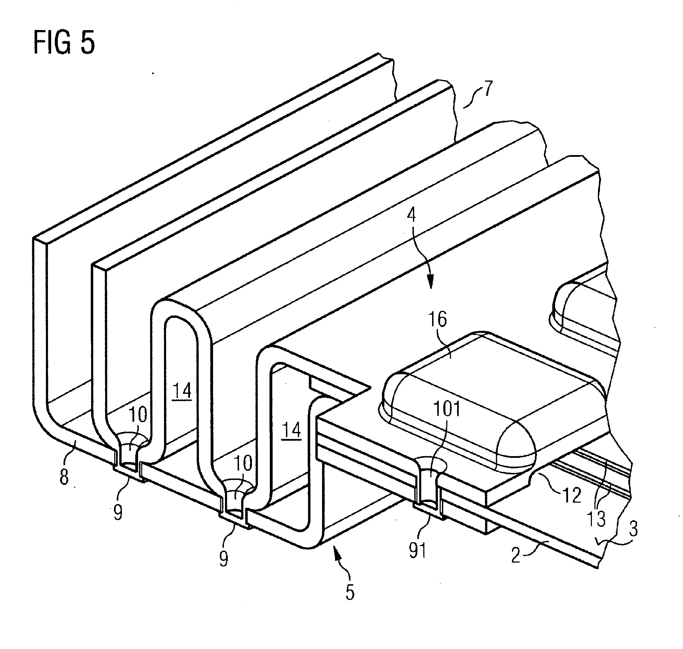

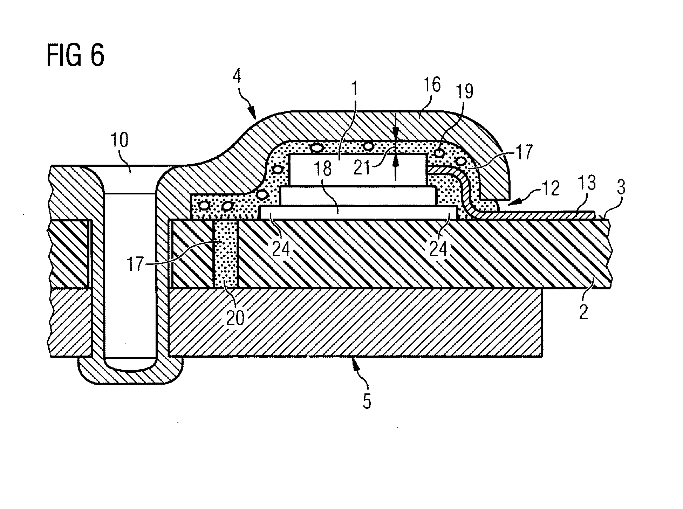

Die Figur 1 zeigt in einer auseinander gezogenen Darstellung ein Ausführungsbeispiel der erfindungsgemäßen Kühlvorrichtung, wie sie im Haushaltsgerätebereich für ein Glaskeramikkochfeld zum Einsatz kommt. Auf einer Lötseite 3 einer Leiterplatte 2 ist im Bereich eines Randes 23 eine Gruppe 6 von leistungselektronischen SMD-Bauelementen 1 zu sehen, die in einer Reihe angeordnet sind. Zur Entwärmung dieser Gruppe 6 von Bauelementen 1 ist ein Kühlkörper 15 vorgesehen, der aus einem Kühlkörper-Oberteil 4 und einem Kühlkörper-Unterteil 5 besteht. Die beiden Kühlkörperteile 4 und 5 sind durch Fließpressen aus einem Metall, zum Beispiel Aluminium oder Kupfer gefertigt. Die Wandstärke beträgt etwa zwei Millimeter. Das Kühlkörper-Oberteil 4 weist kuppenförmige Ausbuchtungen 16 auf. Diese Ausbuchtungen 16 sind durch einen Spalt 21 (Figur 6) zum Bauelement 1 beabstandet und mit einer Wärmeleitpaste 17 (Figur 6) gefüllt. Diese Wärmeleitpaste 17 ist hinsichtlich ihrer Fließeigenschaft hochviskos. Die Paste 17 ist ein thermischer Leiter, aber ein elektrischer Nichtleiter. Beim Zusammenbau werden die beiden Kühlkörperteile 4 und 5 in Richtung der Pfeile 22 aneinander gepresst, wodurch die Wärmeleitpaste 17 die Außenkontur des jeweiligen Bauelementes auf der Lötseite 3 der Leiterplatte 2 umschließt und einen guten wärmeleitenden Kontakt zwischen jeweils einem der Bauelemente 1 und dem Kühlkörper-Oberteil 4 herstellt. Auf Grund der dielektrischen Eigenschaften der Wärmeleitpaste 17 werden Kurzschlüsse zwischen den leistungselektronischen Bauteilen 1 verhindert, sofern sich diese auf unterschiedlichen elektrischen Potenzialen befinden. Das Kühlkörper-Oberteil 4 weist einen mäanderförmigen Fortsatz 7 auf, der sich vom Rand 23 weg in Richtung der Ebene der Leiterplatte 2 erstreckt. An diesen mäanderförmigen Fortsatz 7 sind an Biegungen, die zum unteren Kühlkörperteil 5 zeigen, Nietdome 10 (Figur 5) ausgebildet. Auch im Bereich der Anlage mit der Leiterplatte 2 sind Nietdome 101 zu sehen. Diese Nietdome 10, 101 werden bei der Formgebung des Fließpressens des Kühlkörper-Oberteils 4 ausgebildet. Beim Zusammenpressen der beiden Teile 4 und 5 werden diese Nietdome 10 bzw. 101 durch Bohrungen 9 bzw. 91, hindurch gesteckt und in einem Pressvorgang jeweils an den Köpfen vernietet. Dadurch entsteht zum einen eine unlösbare, formschlüssige Verbindung zwischen den Teilen 4 und 5. Zum anderen werden nicht nur die beiden Fügepartner 4 und 5, beziehungsweise die dazwischen liegende Leiterplatte 2 zusammen gehalten, sondern auch das Kühlkörper-Oberteil 4 mit dem Kühlkörper-Unterteil 5 wärmeleitend verbunden. Die über die Nietverbindungen transportierte Wärmemenge hängt von der Anzahl der Nietdome ab. Günstig ist, wenn diese Nietdome 101 rundum einer Ausbuchtung 16 angeordnet sind. (Es ist selbstverständlich, dass die Nietdome in entsprechender Weise auch auf dem Kühlkörper-Unterteil 5 ausgebildet sein können.) Der Pressvorgang, sowie das Einbringen der Wärmeleitpaste 17 in die Ausbuchtungen 16, können durch automatische Handhabungswerkzeuge durchgeführt werden, wodurch der Herstellungsprozess der erfindungsgemäßen Anordnung automatisierbar und für die Fertigung in Großserie geeignet ist.

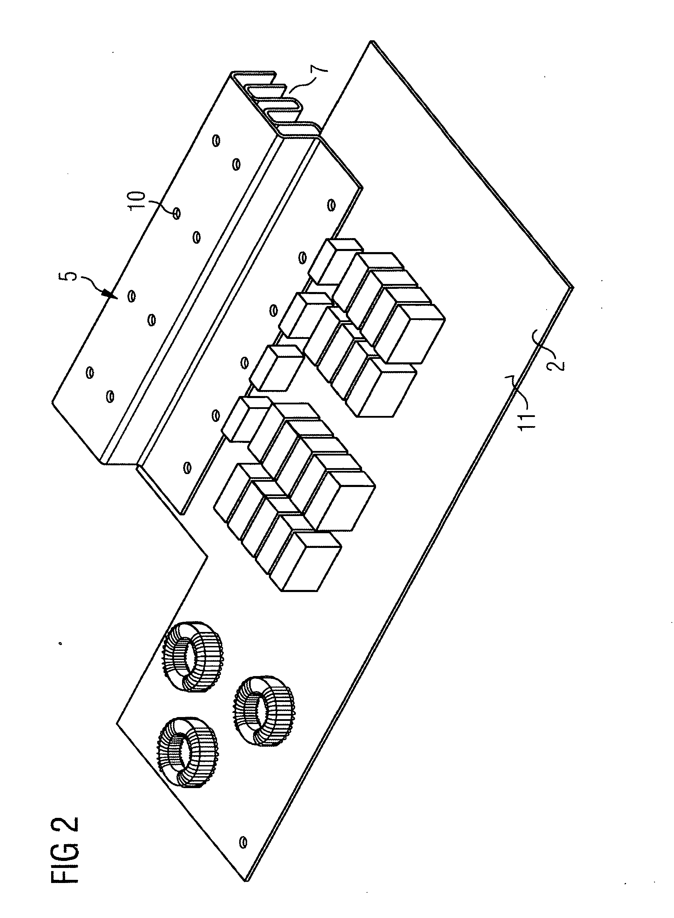

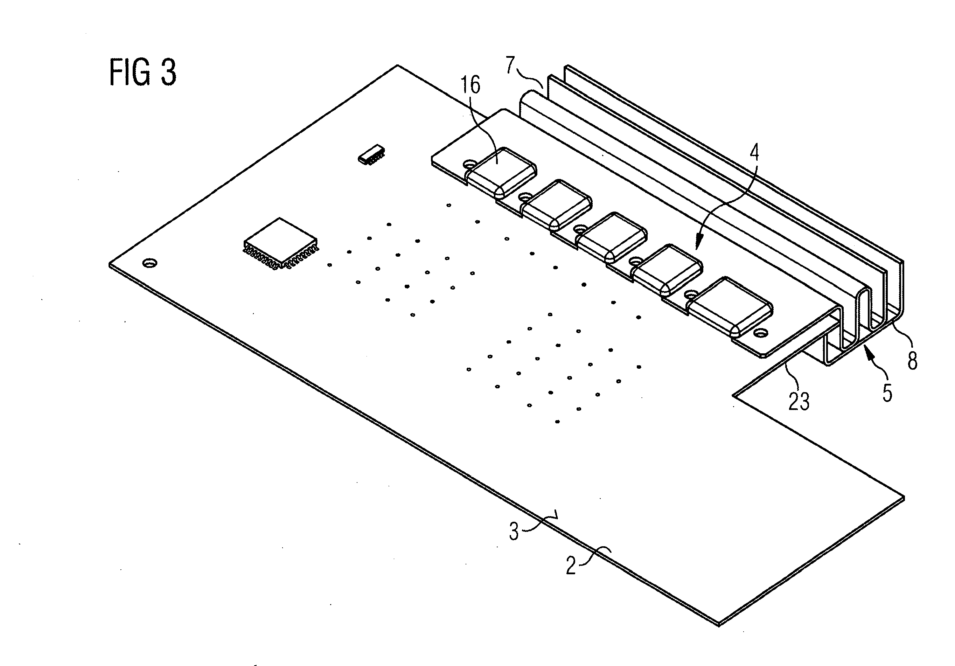

Den zusammengebauten Zustand zeigen in einer perspektivischen Ansicht die Figuren 2 und 3, wobei Figur 2 eine Sicht auf die Bestückungsseite 11 und die Figur 3 eine Sicht auf die Lötseite 3 der Leiterplatte 2 darstellt.

Durch diesen erfindungsgemäßen Aufbau ist es möglich, dass auch bei Verwendung einer herkömmlichen, billigen FR 4 / CEM1 Leiterplatte, die einen gegenüber Kupfer um mehrere Größenordnungen schlechteren Wärmeleitwert aufweist, eine weitaus höhere Verlustleistung von den leistungselektronischen Bauelementen 1 abgeführt werden kann als bislang möglich war. Gegenüber dem Stand der Technik, bei dem Power-SMD-Bauelemente im "Under-rating", d.h. oft nur mit einer Verlustleistung von etwa 5 bis 6 W betrieben wurden, ist es nun - auch bei Verwendung einer kostengünstigen FR4/CEM1-Leiterplatte - möglich, die maximale Verlustleistung auf etwa 20 W pro Bauelement zu steigern. Großvolumige Kühlkörper sind nicht erforderlich, ebenso wenig wie eine kostenaufwendige wärmeableitfähige Leiterplatte. Die erfindungsgemäße Anordnung ist also insbesondere für kostengünstige Anwendungen bei Massenprodukten, wie z.B bei Haushaltsgeräten besonders geeignet.

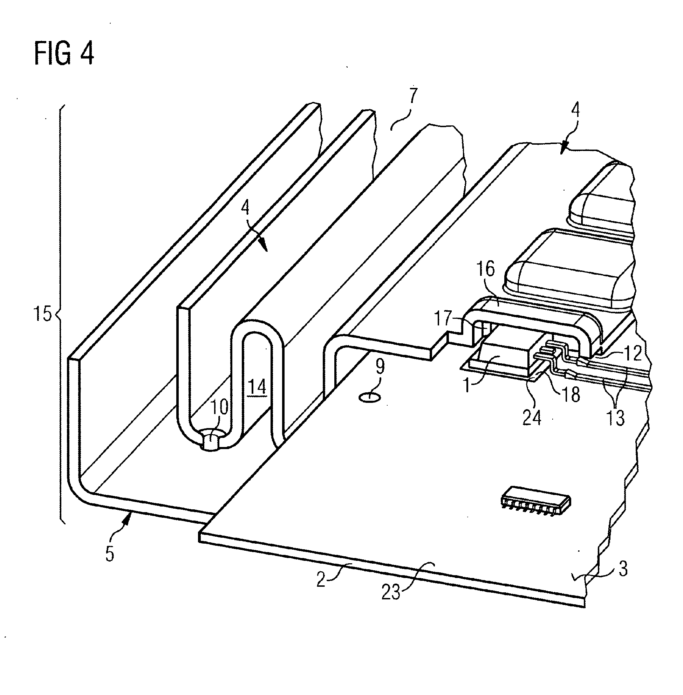

In Figur 4 ist eine Detaildarstellung zu sehen, bei der das Kühlkörper-Oberteil 4 im Bereich einer Ausbuchtung 16 geschnitten dargestellt ist. Das im Schnittbereich darunter liegende Power-SMD-Bauteil 1 ist auf einer Lötfläche 18 aus Kupfer, die auf der Lötseite 3 der Leiterplatte 2 ausgebildet ist, gelötet. Die Lötfläche 18 weist dabei einen überstehenden Rand 24 von etwa 5 mm auf. Dieser Rand 24, der ebenfalls von der Wärmeleitpaste 17 bedeckt ist, ermöglicht es, dass auch der vom Bauteil 1 zur Leiterplatte 2 gerichtete Wärmestrom zumindest teilweise durch das Kühlkörper-Oberteil 4 zum Mäander 7 geleitet wird und dort durch Konvektion an die Umgebungsluft abgeführt werden kann. In der Praxis hat sich eine Randbreite von einigen Millimetern bis hin zu einem Zentimeter als günstig erwiesen.
Die elektrischen Anschlüsse der Bauelemente 1 sind mit Leiterbahnen 13 verbunden, die durch eine Durchführung 12 der jeweiligen Ausbuchtung 16 herausgeführt sind. Die Wärmeleitpaste 17, die aus einem thermisch leitfähigen Elastomer gebildet ist, besitzt eine Fließeigenschaft, die so beschaffen ist, dass die Leiterbahndurchführung 12 auch bei Erwärmung des Bauelements 1, auch nach einer langen Gebrauchsdauer verschlossen bleibt.

Die Figur 5 zeigt eine geschnittene Detaildarstellung, bei der der Schnitt durch die Nietverbindung 9, 10 bzw. 91, 101 der beiden Teile 4 und 5 geführt ist. Die Nietverbindung 91, 101 leistet - wie oben bereits erwähnt- neben der Haltefunktion, auch einen Beitrag zur Entwärmung, indem es einen Teil der in unmittelbarer Nähe anfallenden Verlustleistung auch an das untere Kühlkörperteil 5 weiterleitet.

In Figur 6 ist eine weitere Ausgestaltungsvariante der Erfindung in einer Schnittdarstellung im gezeigt. Die Leiterplatte 2 weist wärmeleitende Durchbrechungen bzw. Löcher 20 auf, die sich beim Zusammenpressen der beiden Teile 4 und 5 mit Wärmeleitpaste 17 füllen. Dadurch werden so genannte "thermische Vias" gebildet, die aber im Gegensatz zum Stand der Technik nicht mit Metall, sondern mit dem thixotropen, wärmeleitenden Elastomer 17 gefüllt sind. M.a.W, die Wärmeleitpaste 17 bildet in diesen Durchbrechungen 20 eine thermische Durchkontaktierung zwischen der das Bauteil 1 umgebene Paste 17 auf der Lötseite 3 der Leiterplatte 2 und dem darunter liegenden Kühlkörper-Unterteil 5.

In der Praxis hat sich als besonders vorteilhaft eine Wärmeleitpaste 17 erwiesen, welche Partikel 19 enthält. Diese Partikel 19 haben bevorzugt einen Durchmesser von etwa 0,2 bis 0,3 Millimeter. Die Partikel 19 wirkten beim Pressvorgang als Distanzhalter und gewährleisten im Spalt 21 einen Mindestabstand zwischen dem Kühlkörper-Oberteil 4 und dem Bauelement 1, d.h. die Innenfläche der kuppenförmigen Ausbuchtungen 16 kann nicht in elektrischen Kontakt mit der Oberfläche eines Bauteils 1 kommen. Dadurch werden Kurzschlüsse verhindert, sofern sich die Bauelemente 1 einer Gruppe auf unterschiedlichen elektrischen Potenzialen befinden.

Die in den Figuren 1 bis 6 dargestellten Nietverbindungen können hinsichtlich ihrer Anordnung und örtlichen Dichte selbstverständlich stark variieren. Es ist günstig, wenn um verlustleistungsintensive Bauelemente 1 herum eine Vielzahl von Nietverbindungen ausgeführt ist, wodurch sich der Anteil der an das Kühlkörper-Unterteil 5 transportierte Wärmemenge entsprechend vergrößert. Es ist auch denkbar, dass die mäanderförmigen Rippen 7 des Kühlkörpers 15 durch eine Vielzahl stachelförmig abstehender Stifte gebildet ist.

### Zusammenstellung der verwendeten Bezugszeichen

- 1: elektronisches Bauelement
- 2: Leiterplatte
- 3: Leiterbahnseite (Lötseite)
- 4: Kühlkörper-Oberteil
- 5: Kühlkörper-Unterteil
- 6: Gruppe von leistungselektronischen Bauelementen
- 7: Mäander
- 8: U-förmiger Abkantung
- 9: Durchbohrung
- 10: Nietdom
- 11: Bestückungsseite
- 12: Leiterbahndurchführung
- 13: Leiterbahn
- 14: Konvektionskanal
- 15: Kühlkörper
- 16: Ausbuchtung
- 17: Wärmeleitpaste
- 18: Lötfläche
- 19: Partikel
- 20: Wärmeleitkanal
- 21: Spalt
- 22: Pfeil
- 23: Rand der Leiterplatte 2
- 24: Rand der Lötfläche 18
- 91: Bohrung
- 101: Nietdom im Bereich der Anlage der Leiterplatte

## Patentansprüche

1. Anordnung zur Kühlung von leistungselektronischen Bauelementen, die in einer Gruppe am Rand einer Leiterplatte (2) angeordnet sind, mit einem Kühlkörper (15), der aus einem jeweils starren Kühlkörper-Oberteil (4) und einem Kühlkörper-Unterteil (5) zusammen gesetzt ist, **dadurch gekennzeichnet, dass** in einem zusammengebauten Zustand der Rand (23) der Leiterplatte (2) zwischen dem Kühlkörper-Oberteil (4) und dem Kühlkörper-Unterteil (5) durch Verbindungsmittel (10, 101, 9, 91) gehalten ist, dass das Kühlkörper-Oberteil (4) Ausbuchtungen (16) aufweist, dass die Innenfläche jeder Ausbuchtung mit der Außenfläche eines Bauelementes durch einen Spalt (21) beabstandet ist, und dass der Spalt (21) mit einer hochviskosen, elektrisch nicht leitenden Wärmeleitpaste (17) gefüllt ist.

2. Anordnung nach Anspruch 1, **dadurch gekennzeichnet, dass** die Ausbuchtungen (16) im Kühlkörper-Oberteil (4) jeweils in Form und Lage der Gruppe der Bauelemente (1) auf der Leiterplatte (2) angepasst ist.

3. Anordnung nach Anspruch 1 oder 2, **dadurch gekennzeichnet, dass** die Wärmeleitpaste (17) Partikel (19) enthält, die in Engestellen des Spalts (21) als Distanzhalter wirken.

4. Anordnung nach Anspruch 3, **dadurch gekennzeichnet, dass** die Partikel (19) eine mittlere Größe von etwa 0,25 Millimeter aufweisen.

5. Anordnung nach einem der Ansprüche 1 bis 4, **dadurch gekennzeichnet, dass** das Kühlkörper-Oberteil (4) eine sich in Ebene der Leiterplatte (2) erstreckend Fortsetzung aufweist, an der Kühlrippen ausgebildet sind.

6. Anordnung nach Anspruch 5, **dadurch gekennzeichnet, dass** die Kühlrippen in Form eines Mäander (7) ausgebildet sind, dessen Biegungen parallel zur Kante des Randes (23) der Leiterplatte (2) verlaufend ausgebildet sind.

7. Anordnung nach Anspruch 6, **dadurch gekennzeichnet, dass** das Kühlkörper-Unterteil (5) eine sich in Ebene der Leiterplatte (2) erstreckende Fortsetzung aufweist, an dem eine, sich parallel zur Kante des Randes (23) der Leiterplatte (2) erstreckende, U-förmige Abkantung (8) ausgebildet ist.

8. Anordnung nach einem der vorstehenden Ansprüche, **dadurch gekennzeichnet, dass** jedes Bauelement (1) ein SMD-Bauelement ist und durch Oberflächenmontage auf eine Lötfläche (18) der Leiterplatte (2) gelötet ist, dass jede Lötfläche (18) einen überstehenden Rand (24) aufweist, der von der Wärmeleitpaste (17) benetzt ist.

9. Anordnung nach einem der vorstehenden Ansprüche, **dadurch gekennzeichnet, dass** in der Leiterplatte (2) Wärmeleitkanäle (20) ausgebildet sind, welche mit Wärmeleitpaste (17) gefüllt sind und welche die Kühlkörper-Oberseite (4) mit der Kühlkörper-Unterseite (5) wärmeleitend verbinden.

10. Anordnung nach einem der vorstehenden Ansprüche, **dadurch gekennzeichnet, dass** durch jedes Verbindungsmittel (10, 101) eine unlösbare formschlüssige Verbindung zwischen Kühlkörper-Oberteil (4) und Kühlkörper-Unterteil (5) hergestellt ist.

11. Anordnung nach Anspruch 10, **dadurch gekennzeichnet, dass** die Verbindungsmittel (9, 10, 91, 101) als Nietverbindungen ausgebildet sind.

12. Anordnung nach Anspruch 11, **dadurch gekennzeichnet, dass** die Nietverbindungen durch Nietdome (10, 101) gebildet sind, die am Kühlkörper-Oberteil (4) und/oder am Kühlkörper-Unterteil (5) ausgebildet sind und durch korrespondierende Bohrungen (9, 91) in der Leiterplatte (2) hindurchgeführt und am Kopf des jeweiligen Nietdoms (10, 101) vernietet sind.

13. Anordnung nach Anspruch 12, **dadurch gekennzeichnet, dass** um eine Ausbuchtung (16) herum mehrere Nietdome (10, 101) angeordnet sind.

14. Anordnung nach einem der vorstehenden Ansprüche, **dadurch gekennzeichnet, dass** die Größe des Spalts (21) etwa 0,2 Millimeter bis 1 Millimeter beträgt.

15. Anordnung nach einem der vorstehenden Ansprüche, **dadurch gekennzeichnet, dass** die Leiterplatte (2) eine einzige Lötseite (3) aufweist und aus Epoxidharz gebildet ist, das mit Glasfaser verstärkt ist.

16. Anordnung nach einem der vorstehenden Ansprüche, **dadurch gekennzeichnet, dass** die Wärmeleitpaste (17) aus einem thermisch leitfähigen Elastomer gebildet ist.

17. Methode zur Herstellung einer Anordnung nach einem der Ansprüche 1-13, **dadurch gekennzeichnet, dass** das Kühlkörper-Oberteil (4) und das Kühlkörper-Unterteil (5) durch Fließpressen oder Tiefziehen hergestellt werden.

## Claims

1. Arrangement for cooling power-electronic components, which are arranged in a group at the edge of a printed circuit board (2), with a heat sink (15), which comprises a respectively rigid heat sink upper part (4) and a heat sink lower part (5), **characterized in that**, in an assembled state, the edge (23) of the printed circuit board (2) is held by connecting means (10, 101, 9, 91) between the heat sink upper part (4) and the heat sink lower part (5), **in that** the heat sink upper part (4) has bays (16), **in that** the inner surface of each bay is spaced apart from the outer surface of a component by a gap (21), and **in that** the gap (21) is filled with a high-viscosity, electrically non-conductive, thermally conductive paste (17).

2. Arrangement according to Claim 1, **characterized in that** the bays (16) in the heat sink upper part (4) are each matched in terms of shape and position to the group of components (1) on the printed circuit board (2).

3. Arrangement according to Claim 1 or 2, **characterized in that** the thermally conductive paste (17) contains particles (19) which act as spacers at constricted points of the gap (21).

4. Arrangement according to Claim 3, **characterized in that** the particles (19) have a mean size of approximately 0.25 millimetre.

5. Arrangement according to one of Claims 1 to 4,
**characterized in that** the heat sink upper part (4) has a continuation which extends in the plane of the printed circuit board (2) and on which continuation cooling ribs are formed.

6. Arrangement according to Claim 5, **characterized in that** the cooling ribs are in the form of a meander (7), whose bends are formed so as to run parallel to the margin of the edge (23) of the printed circuit board (2).

7. Arrangement according to Claim 6, **characterized in that** the heat sink lower part (5) has a continuation which extends in the plane of the printed circuit board (2) and on which a U-shaped bent-back portion (8), which extends parallel to the margin of the edge (23) of the printed circuit board (2), is formed.

8. Arrangement according to one of the preceding claims, **characterized in that** each component (1) is an SMD component and is soldered onto a soldering surface (18) of the printed circuit board (2) by means of surface mounting, **in that** each soldering surface (18) has a protruding edge (24), which is covered by the thermally conductive paste (17).

9. Arrangement according to one of the preceding claims, **characterized in that** thermally conductive channels (20) are formed in the printed circuit board (2) which are filled with thermally conductive paste (17) and which thermally conductively connect the heat sink upper side (4) to the heat sink lower side (5).

10. Arrangement according to one of the preceding claims, **characterized in that** a releasable interlocking connection is produced between the heat sink upper part (4) and the heat sink lower part (5) by each connecting means (10, 101).

11. Arrangement according to Claim 10, **characterized in that** the connecting means (9, 10, 91, 101) are in the form of riveted joints.

12. Arrangement according to Claim 11, **characterized in that** the riveted joints are formed by riveting domes (10, 101), which are formed on the heat sink upper part (4) and/or on the heat sink lower part (5), and are passed through corresponding bores (9, 91) in the printed circuit board (2) and riveted at the top of the respective riveting dome (10, 101).

13. Arrangement according to Claim 12, **characterized in that** a plurality of riveting domes (10, 101) are arranged around a bay (16) .

14. Arrangement according to one of the preceding claims, **characterized in that** the size of the gap (21) is approximately 0.2 millimetre to 1 millimetre.

15. Arrangement according to one of the preceding claims, **characterized in that** the printed circuit board has a single soldering side (3) and is formed from epoxy resin, which is glass-fibre-reinforced.

16. Arrangement according to one of the preceding claims, **characterized in that** the thermally conductive paste (17) is formed from a thermally conductive elastomer.

17. Method for producing an arrangement according to one of Claims 1-13, **characterized in that** the heat sink upper part (4) and the heat sink lower part (5) are produced by means of extrusion or deep-drawing.

## Revendications

1. Dispositif de refroidissement de composants électroniques de puissance qui sont disposés suivant un groupe au bord d'une plaquette (2) à circuits imprimés, comprenant un dissipateur (15) de chaleur composé d'une partie (4) supérieure rigide et d'une partie (5) inférieure, **caractérisé en ce qu'**à l'état monté le bord (23) de la plaquette (2) à circuits imprimés est maintenu entre la partie (4) supérieure un dissipateur de chaleur et la partie (5) inférieure du dissipateur de chaleur par des moyens (10, 101, 9, 91) de liaison, **en ce que** la partie (4) supérieure du dissipateur de chaleur a des indentations (16), **en ce que** la surface intérieure de chaque indentation est à distance de la surface extérieure d'un composant par un intervalle (21) et **en ce que** l'intervalle (21) est empli d'une pâte (17) conductrice de la chaleur, très visqueuse et ne conduisant pas l'électricité.

2. Dispositif suivant la revendication 1, **caractérisé en ce que** les indentations (16) de la partie (4) supérieure du dissipateur de chaleur sont adaptées respectivement en forme et en position au groupe des composants (1) sur la plaquette (2) à circuits imprimés.

3. Dispositif suivant la revendication 1 ou 2, **caractérisé en ce que** la pâte (17) conductrice de la chaleur contient des particules (19) qui servent d'entretoise dans les endroits étroits de l'intervalle (21).

4. Dispositif suivant la revendication 3, **caractérisé en ce que** les particules (19) ont une dimension moyenne d'environ 0,25 mm.

5. Dispositif suivant l'une des revendications 1 à 4, **caractérisé en ce que** la partie (4) supérieure du dissipateur de chaleur a un prolongement qui s'étend dans le sens de la plaquette (2) à circuits imprimés et sur lequel sont formées des ailettes de refroidissement.

6. Dispositif suivant la revendication 5, **caractérisé en ce que** les ailettes de refroidissement ont une forme sinueuse (7) dont les courbures s'étendent parallèlement à l'arête du bord (23) de la plaquette (22) à circuits imprimés.

7. Dispositif suivant la revendication 6, **caractérisé en ce que** la partie (5) inférieure du dissipateur de chaleur a un prolongement qui s'étend dans le plan de la plaquette (2) à circuits imprimés et sur lequel est formée une partie (8) en forme de U s'étendant parallèlement à l'arête du bord (23) de la plaquette (2) à circuits imprimés.

8. Dispositif suivant l'une des revendications précédentes, **caractérisé en ce que** chaque composant (1) est un composant SMD et est brasé par un montage de surface sur une surface (18) de brasage de la plaquette (2) à circuits imprimés, **en ce que** chaque surface (18) de brasage a un bord (24) en saillie qui est mouillé par la pâte (17) conductrice de la chaleur.

9. Dispositif suivant l'une des revendications précédentes, **caractérisé en ce que** dans la plaquette (2) à circuits imprimés sont formés des canaux (20) de propagation de la chaleur qui sont emplis de pâte (17) conductrice de la chaleur et qui relient d'une manière conductrice de la chaleur la face (4) supérieure du dissipateur de chaleur à la face (5) inférieure du dissipateur de chaleur.

10. Dispositif suivant l'une des revendications précédentes, **caractérisé en ce qu'**il est fait, par chaque moyen (10, 101) de liaison, une liaison indéfectible à complémentarité de forme entre la partie (4) supérieure du dissipateur de chaleur et la partie (5) inférieure du dissipateur de chaleur.

11. Dispositif suivant la revendication 10, **caractérisé en ce que** les moyens (9, 10, 91, 101) de liaison sont constitués en rivetages.

12. Dispositif suivant la revendication 11, **caractérisé en ce que** les rivetages sont formés par des dômes (10, 101) de rivets qui sont formés sur la partie (4) supérieure du dissipateur de chaleur et/ou sur la partie (5) inférieure du dissipateur de chaleur et ils passent dans des trous (9, 91) correspondants de la plaquette (2) à circuits imprimés et sont rivetés à la tête du dôme (10, 101) de rivets respectifs.

13. Dispositif suivant la revendication 12, **caractérisé en ce que** plusieurs dômes (10, 101) de rivets sont disposés tout au tour d'une indentation (16).

14. Dispositif suivant l'une des revendications précédentes, **caractérisé en ce que** la dimension de l'intervalle (21) va d'environ 0,2 mm à 1 mm.

15. Dispositif suivant l'une des revendications précédentes, **caractérisé en ce que** la plaquette (2) à circuits imprimés a une face (3) unique de brasure et est en résine époxyde renforcée par de la fibre de verre.

16. Dispositif suivant l'une des revendications précédentes, **caractérisé en ce que** la pâte (17) conductrice de la chaleur est en un élastomère conducteur thermiquement.

17. Procédé de fabrication d'un dispositif selon les revendications 1 à 13, **caractérisé en ce que** l'on fabrique la partie (4) supérieure du dissipateur de chaleur et la partie (5) inférieure du dissipateur de chaleur par filage à la presse ou par emboutissage profond.
